# EUROPEAN PATENT SPECIFICATION

(11) **EP 2 469 587 B1**
(45) Date of publication and mention of the grant of the patent: **08.05.2019**
(21) Application number: 11194495.5
(22) Date of filing: 20.12.2011
(51) Int. Cl.: H01L 21/67

(54) **Groove processing tool and groove processing device for thin-film solar cell**
Rillenbearbeitungswerkzeug und Rillenbearbeitungsvorrichtung für Dünnschicht-Solarzelle
Outil de traitement de rainure et dispositif de traitement de rainure pour cellule solaire à couche mince

(30) Priority: 21.12.2010 JP 2010284057; 25.10.2011 JP 2011233581
(43) Date of publication of application: 27.06.2012
(73) Proprietor: Mitsuboshi Diamond Industrial Co., Ltd., Suita-city, Osaka 564-0044 (JP)
(72) Inventor: Soyama, Masanobu, Suita City, Osaka 564-0044 (JP); Mizota, Tomohiko, Suita City, Osaka 564-0044 (JP); Yamada, Mitsuru, Suita City, Osaka 564-0044 (JP)
(74) Representative: TBK

(56) References cited:
- WO-A1-2010/098306
- JP-A- H04 135 104
- JP-A- H10 328 922
- US-A1- 2008 229 893

## Description

The present invention relates to a groove processing tool for a thin-film solar cell, particularly to a groove processing tool held by a holder and configured to be reciprocated relatively to an integrated substrate of the thin-film solar cell together with the holder along a prospective scribing line on the integrated substrate in order to form a groove on the integrated substrate.

Further, the present invention relates to a groove processing device, particularly to a groove processing device configured to move a groove processing tool relatively to an integrated substrate of a thin-film solar cell along a prospective scribing line on the integrated substrate in order to form a groove on the integrated substrate.

### Background Art

The thin-film solar cells are normally manufactured with a method described in, for instance document JP S63-016439 U. In the method described in document JP S63-016439 U, a lower electrode layer (a Mo layer) is formed atop a substrate made of glass or the like. Subsequently, the lower electrode layer is divided into strips by forming grooves therein. Next, compound semiconductor layers, including a chalcopyrite structure compound semiconductor layer (e.g., a CIGS layer), is formed atop the lower electrode layer. The compound semiconductor layers are partially removed in a stripe shape and are divided into strips by forming grooves therein. Subsequently, an upper electrode layer is formed for covering the processed compound semiconductor layers. Finally, the upper electrode layer is partially removed in a stripe shape and is divided into strips by forming grooves therein.

Mechanical scribing has been used as a groove processing technology for the aforementioned manufacturing processing. Mechanical scribing is a method of partially removing a thin film with a mechanical tool made of e.g., diamond. Document JP 2002-033498 A proposes a method for processing a groove with constant width by means of mechanical scribing. In the method described in document JP 2002-033498 A, a groove processing tool and a removing tool are used. The groove processing tool is herein embedded with a processing load regulating mechanism configured to regulate processing load.

In the well-known groove processing device or the well-known groove processing method, a series of the following actions is repeated for sequentially forming a plurality of grooves. Every time a groove is processed, a head is elevated and moved to a processing starting position. Subsequently, the next groove is processed. In the well-known device and method, a long period of time is required for processing grooves. Further, previously regulated pressure of the tool may be required to be regulated again.

In view of the above, inventors of the present application developed a processing device for efficiently and quickly processing a groove and filed a patent application thereof (published as JP 2010-082953 A). In the processing device, a tool holder is attached to a head while being movable up and down. Further, a pivot member is attached to the tool holder while being pivotable within a predetermined angular range. The pivot member holds a groove processing tool. The pivot member is flipped between a forward cutting position in outgoing movement and a rearward cutting position in returning movement. Further, the groove processing tool includes a pair of symmetric front and rear cutting edges on the tip thereof. Specifically, the front cutting edge is formed on the outgoing side of the tip, while the rear cutting edge is formed on the returning side of the tip. The front cutting edge is configured to make contact with a substrate of a solar cell when the pivot member is set to be in the forward (i.e., outgoing) cutting position. On the other hand, the rear cutting edge is configured to make contact with the substrate of the solar cell when the pivot member is set to be in the rearward (i.e., returning) cutting position.

Now, the inventors of the present application found that an angular range of 50 to 80 degrees is most appropriate as the tilt angle of the well-known groove processing tool in groove processing. Specifically, when the groove processing tool is tilted at an angle of less than 50 degrees, a contact area is enlarged between the cutting edge and the substrate. Contact resistance is thereby increased in groove processing. When the groove processing tool is tilted at an angle of greater than 80 degrees, on the other hand, performance of discharging fragments removed from a layer may be degraded, and further, so-called a skip (i.e., an unprocessed portion) may be produced in groove processing.

Based on the above, the aforementioned processing device developed by the inventors of the present application is configured to execute groove processing while the groove processing tool is tilted at an angle of 70 degrees. In this case, it is required to set the pivot angle of the pivot member to be an angular range of 40 degrees (i.e., ± 20 degrees). In other words, the pivot angle of the pivot member is set to be +20 degrees in outgoing movement while being set to be -20 degrees in returning movement.

However, a mechanism for switching the position of the pivot member, including a mechanism for supplying outdoor air, is required for executing groove processing with the pivot member tilted (i.e., postured) as described above. Further, in pivoting the pivot member and the groove processing tool in an angular range of ± 20 degrees, vertical moving distance of the tip of the groove processing tool is increased due to the large pivot angular range. Therefore, it is required to execute a switching control of elevating and moving the pivot member and the groove processing tool to retracted positions in switching between outgoing movement and returning movement. Accordingly, so-called "takt time" is increased and this results in cost increase. Yet further, groove processing accuracy varies due to the large pivot angle. In other words, it is difficult to execute highly accurate groove processing.

Document WO 2010/098306 A1 discloses a solar cell manufacturing tool having rather a rectangular shape in section. In order to perform cutting, the tool has to be slanted such that its sides form an angle between 50° and 80° with the surface of the work.

Document US 2008/0229893 A1 discloses a tool for performing metal forming operations.

Document JP H04-135104 A discloses a generic groove machining tool.

Document JP H10328922 A discloses another generic groove machining tool for fine grooving.

It is the object of the present invention to reliably execute highly accurate groove processing with a simple structure, and simultaneously, reliably execute efficient groove processing.

The object of the invention is achieved by a groove processing tool according to claim 1. Advantageous embodiments are carried out according to the dependent claims.

A groove processing tool for a thin-film solar cell according to a first aspect of the present invention is held by a holder and configured to be reciprocated relatively to an integrated substrate of the thin-film solar cell together with the holder along a prospective scribing line on the integrated substrate for forming a groove on the integrated substrate. The groove processing tool includes a tool body and a blade end. The tool body is held by the holder. The blade end is formed on a tip of the tool body. The blade end includes a pair of an outgoing-side cutting edge and a returning-side cutting edge on a tip thereof in reciprocating directions. Further, the blade end includes a pair of an outgoing-side lateral face and a returning-side lateral face in the reciprocating directions. The outgoing-side and returning-side lateral faces are tilted and symmetrically formed for reducing a width of the blade end in the reciprocating directions towards the tip of the blade end.

The groove processing tool for a thin-film solar cell is configured to be reciprocated and thereby form a groove on the integrated substrate in both outgoing movement and returning movement. Further, the outgoing-side lateral face and the returning-side lateral face are tilted. Therefore, the tilt angle of the groove processing tool can be reduced by the tilt angle of the outgoing/returning-side lateral surface in groove processing.

When the aforementioned groove processing tool is attached to a processing device, the pivot angle of a member for holding the groove processing tool can be restricted to a smaller angular range. Therefore, the mechanism for switching the posture of the groove processing tool can be simply formed. Further, the vertical moving distance, required for the groove processing tool in switching its posture, is reduced due to the smaller pivot angular range of the member for holding the groove processing tool. This results in reduction in the takt time. Yet further, it is possible to inhibit degradation in groove processing accuracy in switching the posture of the groove processing tool due to the smaller pivot angular range of the member for holding the groove processing tool.

A groove processing tool for a thin-film solar cell according to a second aspect of the present invention relates to the groove processing tool for a thin-film solar cell according to the first aspect of the present invention. In the groove processing tool for a thin-film solar cell, each of the cutting edges of the blade end has a linear shape. Further, a rake angle of the outgoing-side lateral face with respect to the outgoing-side cutting edge and a rake angle of the returning-side lateral face with respect to the returning-side cutting edge are respectively set to be greater than or equal to 50 degrees and less than or equal to 80 degrees.

An appropriate tilt angle of the groove processing tool is set to be roughly 70 degrees in groove processing. Therefore, it is possible to greatly reduce the pivot angle required for switching the posture of the groove processing tool by setting the both rake angles to be in a range of greater than or equal to 50 degrees and less than or equal to 80 degrees.

A groove processing tool for a thin-film solar cell according to a third aspect of the present invention relates to the groove processing tool for a thin-film solar cell according to the second aspect of the present invention. In the groove processing tool for a thin-film solar cell, the width of the tip of the blade end in groove forming directions is set to be greater than or equal to 50 µm and less than or equal to 200 µm.

A groove processing device for a thin-film solar cell according to a fourth aspect of the present invention is configured to move a groove processing tool relatively to an integrated substrate of the thin-film solar cell along a prospective subscribing line on the integrated substrate for forming a groove on the integrated substrate. The groove processing device includes a table, a head and a moving mechanism. The table allows the integrated substrate to be disposed thereon. The head allows the groove processing tool recited in one of claims 1 to 3 to be attached thereto. The moving mechanism is configured to move the table and the head relatively to each other within a horizontal plane. Further, the head includes a holder, a pivot member and a pressure member. The holder is movable up and down. The pivot member holds the groove processing tool. The pivot member is pivotably supported by the holder about a pivot axis arranged perpendicular to the groove forming directions. The pressure member is configured to press the groove processing tool held by the holder onto the integrated substrate with a predetermined force.

In the groove processing device for a thin-film solar cell, the groove processing tool according to one of the first to third aspects of the present invention is held by the pivot member of the head. Further, the groove processing tool is pressed onto the substrate by means of the pressure member with a predetermined force. In relatively moving the table and head along the prospective scribing line under the condition, the pivot member holding the groove processing tool pivots at a predetermined angle in response to the movement. In other words, the groove processing tool takes an appropriate processing posture.

According to the groove processing device for a thin-film solar cell of the fourth aspect of the present invention, the outgoing-side face and the returning-side face of the groove processing tool are tilted. Similarly to the above, the pivot angle of the pivot member holding the groove processing device can be restricted to a smaller angular range. Therefore, the mechanism for switching the posture of the groove processing tool can be simply formed. Further, it is possible to reduce a period of time required for switching the posture of the groove processing tool. Yet further, it is possible to inhibit degradation in groove processing accuracy in switching the posture of the groove processing tool.

A groove processing device for a thin-film solar cell according to a fifth aspect of the present invention relates to the groove processing device for a thin-film solar cell according to the fourth aspect of the present invention. In the groove processing device for a thin-film solar cell, the pivot member is pivotable about the pivot axis within an angular range of ± 5 degrees.

A groove processing device for a thin-film solar cell according to a sixth aspect of the present invention relates to the groove processing deice for a thin-film solar cell according to the fifth aspect of the present invention. The groove processing device for a thin-film solar cell further includes a neutral position maintaining unit and a stopper. The neutral position maintaining unit is configured to maintain the pivot member in a neutral position except for during groove processing. The stopper is configured to restrict the pivot member from pivoting across the angular range of ± 5 degrees.

According to the groove processing device for a thin-film solar cell of the sixth aspect of the present invention, it is possible to prevent the pivot member from pivoting at a larger angle.

A groove processing device for a thin-film solar cell according to a seventh aspect of the present invention relates to the groove processing device for a thin-film solar cell according to the sixth aspect of the present invention. In the groove processing device for a thin-film solar cell, the neutral position maintaining unit includes a pair of elastic members. The elastic members are configured to urge the pivot member to the neutral position, while interposing the pivot member therebetween.

A groove processing device for a thin-film solar cell according to an eighth aspect of the present invention relates to the groove processing device for a thin-film solar cell according to the seventh aspect of the present invention. In the groove processing device for a thin-film solar cell, the elastic members are coil springs.

A groove processing device for a thin-film solar cell according to a ninth aspect of the present invention relates to the groove processing device for a thin-film solar cell according to the seventh aspect of the present invention. In the groove processing device for a thin-film solar cell, the elastic members are both made of soft rubber.

A groove processing device for a thin-film solar cell according to a tenth aspect of the present invention relates to the groove processing device for a thin-film solar cell according to the seventh aspect of the present invention. In the groove processing device for a thin-film solar cell, the elastic members are plate springs.

A groove processing device for a thin-film solar cell according to an eleventh aspect of the present invention relates to the groove processing device for a thin-film solar cell according to the sixth aspect of the present invention. In the groove processing device for a thin-film solar cell, the neutral position maintaining unit includes a magnetic member and a magnet. The magnetic member is disposed at least on an upper tip of the pivot member. The magnet is disposed on the holder while being opposed to the magnetic member at a predetermined clearance.

A groove processing device for a thin-film solar cell according to a twelfth aspect of the present invention relates to the groove processing device for a thin-film solar cell according to one of the sixth to eleventh aspects of the present invention. In the groove processing device for a thin-film solar cell, the stopper is fixed to the holder and includes a pair of contact surfaces. The contact surfaces interpose therebetween the upper tip of the pivot member maintained in the neutral position at predetermined clearances.

A groove processing device for a thin-film solar cell according to a thirteenth aspect of the present invention relates to the groove processing device for a thin-film solar cell according to one of the sixth to eleventh aspects of the present invention. In the groove processing device for a thin-film solar cell, the stopper is fixed to the holder and includes a pair of contact members. The contact members are opposed to both pivot-directional lateral faces of the pivot member maintained in the neutral position at predetermined clearances.

Overall, according to the aforementioned aspects of the present invention, highly accurate groove processing can be reliably executed with a simple structure while efficient groove processing can be reliably executed.

### BRIEF DESCRIPTION OF THE DRAWINGS

Referring now to the attached drawings which form a part of this original disclosure:
FIG 1 is an external perspective view of a groove processing device employing an exemplary embodiment of the present invention;
FIG 2 is a front view of a head of the groove processing device;
FIG 3 includes front and side views of a groove processing tool to be attached to the groove processing device;
FIG 4 includes schematic diagrams for explaining actions in groove processing;
FIG 5 is a diagram illustrating a neutral position maintaining unit and a stopper according to another exemplary embodiment of the present invention;
FIG. 6 is a diagram illustrating a neutral position maintaining unit and a stopper according to yet another exemplary embodiment of the present invention; and
FIG. 7 is a diagram illustrating a neutral position maintaining unit and a stopper according to yet another exemplary embodiment of the present invention.

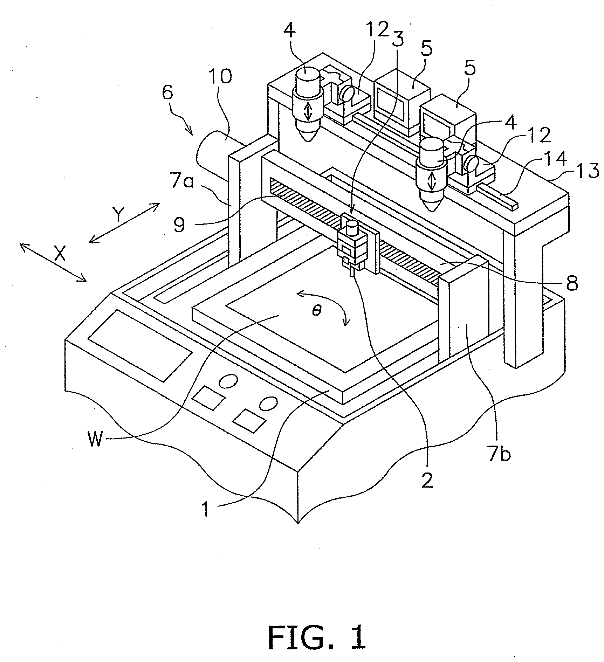

FIG. 1 illustrates an external perspective view of a scribing device for an integrated thin-film solar cell employing an exemplary embodiment of the present invention.

### Entire Structure of Scribing Device

The scribing device includes a table 1, a head 3, two cameras 4 and two monitors 5. The table 1 is provided for disposing a solar cell substrate W thereon. The head 3 includes a groove processing tool 2 (hereinafter simply referred to as "a tool 2") attached thereto.

The table 1 is movable in a Y direction within a horizontal plane as depicted in FIG 1. Further, the table 1 is rotatable at an arbitrary angle within the horizontal plane. It should be noted that FIG. 1 schematically illustrates the appearance of the head 3. The head 3 will be hereinafter explained in detail in the following paragraphs.

A moving support mechanism 6 is configured to move the head 3 above the table 1 in X and Y directions. It should be noted that the X direction is perpendicular to the Y direction within the horizontal plane as illustrated in FIG 1. The moving support mechanism 6 includes a pair of support columns 7a and 7b, a guide bar 8 and a motor 10. The guide bar 8 is disposed between the support columns 7a and 7b. The motor 10 is configured to drive a guide 9 formed on the guide bar 8. The head 3 is movable along the guide 9 in the X direction as described above.

Each camera 4 is fixed onto a base 12. Each base 12 is movable along a guide 14 that is disposed on a support base 13 and extended along the X direction. Each camera 4 is movable up and down and an image recorded by each camera 4 is displayed on the corresponding one of the monitors 5.

### Head

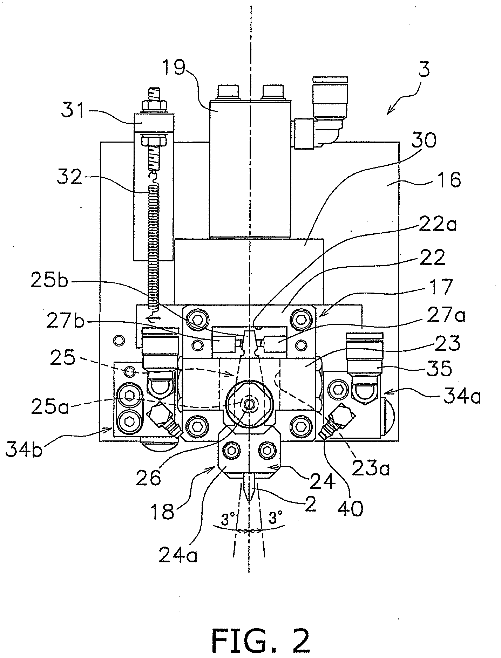

FIG. 2 selectively illustrates the main components of the head 3. The head 3 includes a plate-shaped base 16, a holder 17, a pivot member 18 and an air cylinder 19 (an exemplary pressure member).

The holder 17 is supported by the base 16 through a rail (not illustrated in the figures) while being slidable up and down. The holder 17 includes a holder body 22 and a support member 23 fixed to the surface of the holder body 22. The holder body 22 has a plate shape and includes an opening 22 on an upper part thereof. The support member 23 is a transversely elongated rectangular member. The support member 23 includes a through hole 23a in the inside thereof. The through hole 23a allows the pivot member 18 to pass therethrough.

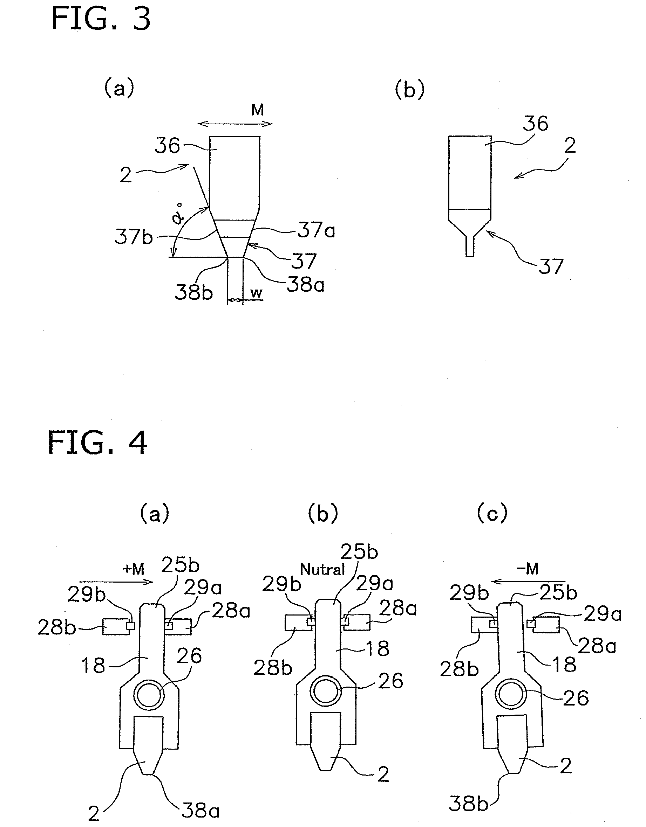

The pivot member 18 includes a tool attached portion 24 and an extended portion 25. The tool attached portion 24 forms a lower part of the pivot member 18. The extended portion 25 is upwardly extended from the tool attached portion 24. The tool attached portion 24 includes a groove. The tool 2 is inserted into the groove and is fixed therein by means of a fixation plate 24a. The extended portion 25 includes a hole 25a horizontally penetrating a lower part thereof in a direction perpendicular to groove forming directions. Further, the pivot member 18 is pivotable about a pin 26 penetrating the hole 25a. A pair of restricting members 27a and 27b is disposed on the right and left sides of the extended portion 25. As illustrated in FIGS. 4 (a) to 4 (c), each restricting member 27a/27b includes a tubular member 28a/28b (an exemplary stopper) and a spring 29a/29b (an exemplary neutral position maintaining unit). The tubular members 28a and 28b are fixed to the holder body 22. The spring 29a is inserted into the tubular member 28a, while the spring 29b is inserted into the tubular member 28b. The pivot member 18 is maintained in a neutral position illustrated in FIG 4 (b) when the tips of the springs 29a and 29b are abutted to the upper tip 25b of the extended portion 25. When pivoting, on the other hand, the pivot member 18 presses either of the springs 29a and 29b and the upper tip 25b of the extended portion 25 is thereby abutted to either of the tubular members 28a and 28b. Accordingly, the pivot angle of the pivot member 18 is restricted. In the present exemplary embodiment, the pivot angle of the pivot member 18 is configured to be restricted to an angular range of ± 3 degrees. However, the pivot angle of the pivot member 18 is preferably restricted to an angular range of ± 5 degrees.

The air cylinder 19 is fixed to the top surface of a cylinder support member 30. The cylinder support member 30 is fixed to the base 16 while being disposed above the holder 17. The cylinder support member 30 includes a through hole vertically penetrating therethrough. A piston rod (not illustrated in the figures) of the air cylinder 19 penetrates the through hole, and the tip of the piston rod is coupled to the holder 17.

Further, the base 16 includes a spring support member 31 on the upper part thereof. A spring 32 is disposed vertically between the spring support member 31 and the holder 17. The holder 17 is upwardly urged by means of the spring 32. The weight of the holder 17 is roughly cancelled out by means of the spring 32.

A pair of air supply units 34a and 34b is disposed on the right and left sides of the holder 17. The air supply units 34a and 34b are structured identical to each other. Each of the air supply units 34a and 34b includes a joint 35 and an air nozzle 40.

### Tool

FIGS. 3 (a) and 3 (b) illustrate the tool 2 in detail. Specifically, FIG 3 (a) illustrating a front view of the tool 2 while FIG 3 (b) illustrates a side view of the tool 2. In FIG. 3 (a), the moving direction of the tool 2 is depicted with a two-headed arrow M.

The tool 2 includes a tool body 36 and a blade end 37. The tool body 36 is held by the holder 17. The blade end 37 is formed on the tip of the tool body 36. The blade end 37 includes cutting edges 38a and 38b on the both sides of the tip thereof. In the present exemplary embodiment, one of the cutting edges (i.e., the cutting edge 38a) functions as a cutting edge for processing a groove in outgoing movement, whereas the other of the cutting edges (i.e., the cutting edge 38b) functions as a cutting edge for processing a groove in returning movement.

Specifically, the blade end 37 has a width w (see FIG 3 (a)) in a moving direction. The width w is reduced towards the tip of the blade end 37. More specifically, the blade end 37 includes lateral faces 37a and 37b. The lateral faces 37a and 37b are opposed and formed symmetric to each other. The lateral face 37a is an outgoing movement side face, while the lateral face 37b is a returning movement side face. The tip of the blade end 37 has a horizontally linear shape in a neutral position, i.e., when the tool 2 is attached to the holder 17 (through the pivot member 18). In the present exemplary embodiment, an angle of 70 degrees is set as a rake angle α of the lateral face 37a of the outgoing movement side with respect to the cutting edge 38a and that of the lateral face 37b of the returning movement side with respect to the cutting edge 38b. It should be noted that the rake angle is preferably greater than or equal to 50 degrees and less than or equal to 80 degrees. Further, the width w of the tip of the blade end 37 in the groove forming directions is preferably greater than or equal to 50 µm and less than or equal to 200 µm.

### Groove Processing Action

In processing a groove on a thin-film solar cell substrate using the aforementioned device, the moving mechanism 6 moves the head 3 and the table 1 and positions the tool 2 on a prospective scribing line using the cameras 4 and the monitors 5.

After the aforementioned positional alignment, the air cylinder 19 is driven for lowering the holder 17 and the pivot member 18. Accordingly, the tip of the tool 2 makes contact with a thin film. Pressure of the tool 2, applied to the thin film, is herein regulated by means of air pressure to be supplied to the air cylinder 19.

Next, the motor 10 is driven for causing the head 3 to scan along the prospective scribing line. FIGS. 4 (a) to 4 (c) schematically illustrate the postures of the pivot member 18 and the tool 2 in the scanning by the head 3.

As illustrated in FIG 4 (a), the pivot member 18 pivots about the pin 26 in the clockwise direction in outgoing movement (i.e., rightward movement in FIG 4 (a)) by means of contact resistance between the cutting edge 38a and the thin film of the substrate. Pivot of the pivot member 18 is herein restricted by the upper tip 25b of the pivot member 18 abutted to the right-side tubular member 28a. Therefore, the tool 2 is moved in a + M direction while being maintained in the tilt posture represented in FIG 4 (a), i.e., while the cutting edge 38a of the tool 2 makes contact with the thin film of the substrate but the cutting edge 38b does not make contact with the surface of the substrate. A groove is thereby formed on the substrate.

The head 3 is subsequently moved relative to the substrate, and the tool 2 is moved to a position above a prospective scribing line on which the tool 2 is to be lowered and pressed. Similarly to the above, the tool 2 is then pressed onto the thin film of the substrate and the head 3 is moved in an opposite direction to the aforementioned direction.

As illustrated in FIG. 4 (c), the pivot member 18 pivots about the pin 26 in the counterclockwise direction in returning movement (i.e., leftward movement in FIG. 4 (c)) by means of contact resistance between the cutting edge 38b and the thin film of the substrate. Pivot of the pivot member 18 is herein restricted by the upper tip 25b of the pivot member 18 abutted to the left-side tubular member 28b. Therefore, the tool 2 is moved in a - M direction while being maintained in the tilt posture represented in FIG. 4 (c), i.e., while the cutting edge 38b of the tool 2 makes contact with the thin film of the substrate but the cutting edge 38a does not make contact with the surface of the substrate. A groove is thereby formed on the substrate.

It should be noted that air is ejected from the air nozzles 40 of the air supply units 34a and 34b for removing a fraction of the film peeled from the substrate during groove processing or after completion of groove processing.

### Features

In the aforementioned groove processing, the pivot member 18 is configured to pivot at a minute angle (within an angular range of ± 3 degrees in this case). Therefore, an actuator is not required for controlling the posture of the pivot member 18. Further, when the posture of the tool 2 is changed in switching outgoing movement into returning movement, the tool 2 is moved up and down at a small distance due to the pivot angle restricted within an angular range of ± 3 degrees. Therefore, it is not required to execute processing steps, including a step of elevating the holder 17 for separating the tool 2 away from the substrate, in switching outgoing movement into returning movement. Further, amplitude of the tool 2 is small because of the same reason. Therefore, accuracy in groove processing is prevented from being varied. In other words, groove processing can be highly accurately executed.

The present invention is not limited to the aforementioned exemplary embodiment, and a variety of changes and modifications can be herein made without departing from the scope of the present invention.

For example, the numeric values, specified for the rake angle of the tool and the tip length (i.e., tip width) of the tool, are not limited to those in the aforementioned exemplary embodiment, and a variety of changes can be made for them.

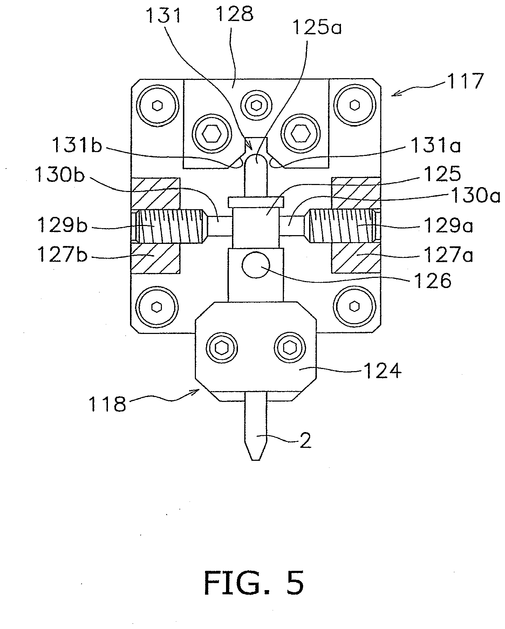

(a) FIG. 5 illustrates a neutral position maintaining unit and a stopper according to another exemplary embodiment. As illustrated in FIG 5, a holder 117 is a rectangular plate member. A pivot member 118 is pivotably supported by the holder 117 through a pin 126. The pivot member 118 includes a tool attached portion 124 and an extended portion 125. The tool attached portion 124 forms a lower part of the pivot member 118. The extended portion 125 is upwardly extended from the tool attached portion 124. The tool 2 is inserted and fixed into the tool attached portion 124.

A pair of blocks 127a and 127b is disposed on the right and left side parts of the holder 117. Each of the blocks 127a and 127b includes a screw hole transversely penetrating therethrough. Screw members 129a and 129b are respectively screwed into the screw holes of the block 127a and 127b. Further, soft rubber members 130a and 130b are respectively fixed to the tips of the screw members 129a and 129b. The tips of the soft rubber members 130a and 130b make contact with the pivot-directional lateral surfaces of the extended portion 125 of the pivot member 118.

In the aforementioned structure, the tips of the soft rubber members 130a and 130b make contact with the both lateral surfaces of the extended portion 125. Under the condition, the pivot member 118 is maintained in the neutral position. When the head reciprocatingly pivots in groove processing, the rubber members 130a and 130b are elastically deformed in response to pivot of the pivot member 118. Thus, the aforementioned structure does not prevent pivot of the pivot member 118.

Further, a stopper 128 is fixed to the upper part of the holder 117. The stopper 128 includes an inverted-V shaped groove 131 on the bottom surface thereof. An upper tip 125a of the extended portion 125 of the pivot member 118 is extended into the groove 131 from below. Predetermined clearances are produced between the upper tip 125a of the extended portion 125 and sidewalls 131a and 131b (an exemplary contact surface) of the groove 131.

According to the aforementioned structure, the upper tip 125a makes contact with the sidewall 131 or 131b of the groove 131 when the pivot member 118 pivots at a predetermined angle. Thus, the pivot angle of the pivot member 118 is restricted. Similarly to the aforementioned exemplary embodiment, the pivot member 118 is herein allowed to pivot within an angular range of exemplary embodiment, the pivot member 118 is herein allowed to pivot within an angular range of ± 3 degrees.

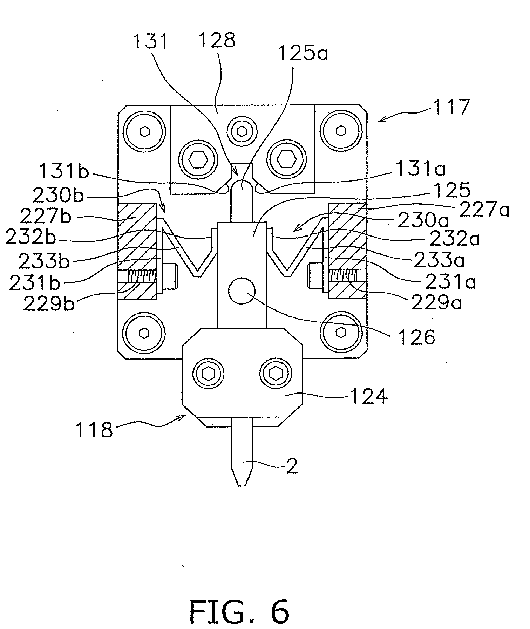

(b) FIG 6 illustrates a neutral position maintaining unit according to yet another exemplary embodiment. The exemplary embodiment illustrated in FIG 6 is basically the same as that illustrated in FIG 5, excluding a neutral position maintaining unit. Therefore, the same reference numerals are used for denoting corresponding components in FIGS. 5 and 6.

As illustrated in FIG 6, a pair of blocks 227a and 227b is disposed on the right and left side parts of the holder 117. Each of the blocks 227a and 227b includes a screw hole transversely penetrating therethrough. A plate spring 230a is disposed between the block 227a and the extended portion 125 of the pivot member 118, while a plate spring 230b is disposed between the block 227b and the extended portion 125 of the pivot member 118.

Each plate spring 230a/230b includes a fixed portion 231a/231b, an abutted portion 232a/232b and a coupling portion 233a/233b. The fixed portion 231a is abutted to the block 227a, while the fixed portion 231b is abutted to the block 227b. The abutted portion 232a is partially abutted to one of the pivot-directional lateral surfaces of the extended portion 125, while the abutted portion 232b is partially abutted to the other of the pivot-directional lateral surfaces of the extended portion 125. The coupling portion 233a couples the upper end of the fixed portion 231a and the bottom end of the abutted portion 232a. Likewise, the coupling portion 233b couples the upper end of the fixed portion 231b and the bottom end of the abutted portion 232b. The fixed portion 231a is fixed to the block 227a by means of a screw member 229a, while the fixed portion 231b is fixed to the block 227b by means of a screw member 229b. Further, the abutted portions 232a and 232b are abutted to the lateral surfaces of the extended portion 125 at vertical positions higher than the pin 126.

According to the aforementioned structure, the abutted portions 232a and 232b of the plate springs 230a and 230b are abutted to the both lateral surfaces of the extended portion 125. Under the condition, the pivot member 118 is maintained in the neutral position. When the head reciprocatingly pivots in groove processing, the plate springs 230a and 230b are elastically deformed in response to pivot of the pivot member 118. Thus, the aforementioned structure does not prevent pivot of the pivot member 118.

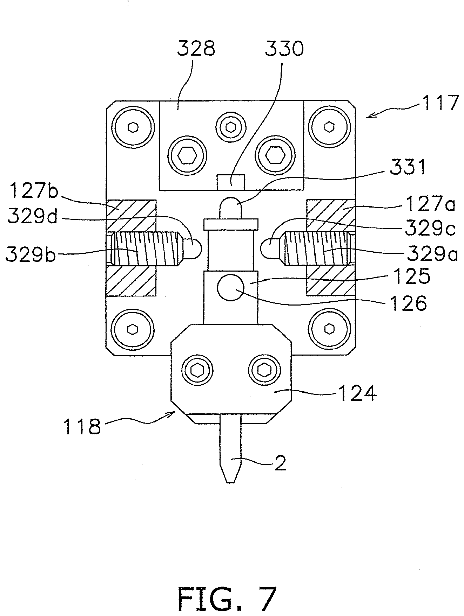

(c) FIG 7 illustrates a neutral position maintaining unit and a stopper according to yet another exemplary embodiment. It should be noted that the same reference numerals are used for denoting corresponding components in FIGS. 5 and 7.

A pair of blocks 127a and 127b is disposed on the right and left side parts of the holder 117. Each of the blocks 127a and 127b includes a screw hole transversely penetrating therethrough. Screw members 329a and 329b are respectively screwed into the screw holes of the blocks 127a and 127b. The screw member 329a includes a spherical tip 329c, while the screw member 329b includes a spherical tip 329d. When the pivot member 118 is herein maintained in the neutral position, equal clearances are reliably produced between the lateral surfaces of the pivot member 118and the spherical tips 329c and 329d.

According to the aforementioned structure, each lateral surface of the extended portion 125 makes contact with the corresponding one of the spherical tips 329c and 329d when the pivot member 118 pivots at a predetermined angle. Accordingly, the pivot angle of the pivot member 118 is restricted. Similarly to the aforementioned exemplary embodiment, the pivot member 118 is herein allowed to pivot within an angular range of ± 3 degrees.

Further, an attraction block 328 is fixed to the upper part of the holder 117. The attraction block 328 includes a magnet 330 on the bottom surface thereof. The magnet 330 is opposed at a predetermined clearance to the upper tip of the extended portion 125 of the pivot member 118 maintained in the neutral position. Further, the extended portion 125 includes a metal attracted portion 331 on the upper tip thereof.

According to the aforementioned structure, the metal attraction portion 331, disposed on the upper tip of the extended portion 125, is attracted to the magnet 330. Therefore, the pivot member 118 is maintained in the neutral position while groove processing is not executed. While groove processing is executed, by contrast, the pivot member 118 pivots by means of processing resistance of the tool 2 against attraction force between the magnet 330 and the metal attracted portion 331.

### Reference Signs List

- 1: Table
- 2: Tool
- 3: Head
- 17, 117: Holder
- 18, 118: Pivot member
- 19: Air cylinder
- 27a, 27b, 128: Stopper
- 28a, 28b: Tubular member
- 29a, 29b: Spring
- 130a, 130b: Rubber member
- 131: Groove
- 131a, 131b: Sidewall (Contact surface)
- 230a, 230b: Plate spring
- 329c, 329d: Spherical tip
- 330: Magnet
- 331: Metal attracted portion

## Claims

1. A groove processing tool (2) for a thin-film solar cell, the groove processing tool (2) pivotably held by a holder (17) and configured to be reciprocated relatively to an integrated substrate of the thin-film solar cell together with the holder (17) along a prospective scribing line on the integrated substrate for forming a groove on the integrated substrate while changing a tilt angle of the groove processing tool (2) in outgoing movement and returning movement, the groove processing tool (2) comprising:
a tool body (36) held by the holder (17); and
a blade end (37) formed on a tip of the tool body (36), the blade end (37) including an outgoing-side cutting edge (38a) and a returning-side cutting edge (38b) on a tip thereof in reciprocating directions, the outgoing-side cutting edge (38a) being used in outgoing movement and the returning-side cutting edge (38b) being used in returning movement,
wherein the blade end (37) includes a pair of an outgoing-side lateral face (37a) and a returning-side lateral face (37b) in the reciprocating directions, the outgoing-side and returning-side lateral faces (37a, 37b) tilted and symmetrically formed for reducing a width of the blade end (37) in the reciprocating directions towards the tip of the blade end (37).

2. The groove processing tool (2) for a thin-film solar cell recited in claim 1, wherein
each of the cutting edges (38a, 38b) of the blade end (37) has a linear shape, and
a rake angle (α) of the outgoing-side lateral face (37a) with respect to the outgoing-side cutting edge (38a) and a rake angle of the returning-side lateral face (37b) with respect to the returning-side cutting edge (38b) are respectively set to be greater than or equal to 50 degrees and less than or equal to 80 degrees.

3. The groove processing tool (2) for a thin-film solar cell recited in claim 2, wherein
the width (w) of the tip of the blade end (37) in groove forming directions is set to be greater than or equal to 50 µm and less than or equal to 200 µm.

4. A groove processing device for a thin-film solar cell, the groove processing device configured
to move a groove processing tool (2) relatively to an integrated substrate (W) of the thin-film solar cell along a prospective subscribing line on the integrated substrate for forming a groove on the integrated substrate (W), the groove processing device comprising:
a table (1) allowing the integrated substrate to be disposed thereon;
a head (3) allowing the groove processing tool (2) recited in one of claims 1 to 3 to be attached thereto; and
a moving mechanism (6) configured to move the table (1) and the head (3) relatively to each other within a horizontal plane, wherein
the head includes: a holder (17) movable up and down;
a pivot member (18) holding the groove processing tool (2), the pivot member (18) pivotably supported by the holder (17) about a pivot axis arranged perpendicular to the groove forming directions; and
a pressure member (19) configured to press the groove processing tool (2) held by the holder (17) onto the integrated substrate (W) with a predetermined force.

5. The groove processing device for a thin-film solar cell recited in claim 4, wherein
the pivot member (18) is pivotable about the pivot axis within an angular range of ± 5 degrees.

6. The groove processing device for a thin-film solar cell recited in claim 5, further comprising:
a neutral position maintaining unit (29a, 29b) configured to maintain the pivot member (18) in a neutral position except for during groove processing; and
a stopper (28a, 28b) configured to restrict the pivot member (18) from pivoting across the angular range of ± 5 degrees.

7. The groove processing device for a thin-film solar cell recited in claim 6, wherein
the neutral position maintaining unit (29a, 29b) includes a pair of elastic members interposing the pivot member (18) therebetween, the elastic members configured to urge the pivot member (18) to the neutral position.

8. The groove processing device for a thin-film solar cell recited in claim 7, wherein
the elastic members are coil springs.

9. The groove processing device for a thin-film solar cell recited in claim 7, wherein
the elastic members are both made of soft rubber.

10. The groove processing device for a thin-film solar cell recited in claim 7, wherein
the elastic members are plate springs.

11. The groove processing device for a thin-film solar cell recited in claim 6, wherein
the neutral position maintaining unit (29a, 29b) includes a magnetic member disposed at least on an upper tip of the pivot member (18); and
a magnet disposed on the holder (17), the magnet opposed to the magnetic member at a predetermined clearance.

12. The groove processing device for a thin-film solar cell recited in one of claims 6 to 11, wherein
the stopper (28a, 28b) is fixed to the holder (17), the stopper (28a, 28b) including a pair of contact surfaces interposing therebetween the upper tip of the pivot member (18) maintained in the neutral position at predetermined clearances.

13. The groove processing device for a thin-film solar cell recited in one of claims 6 to 11, wherein
the stopper (28a, 28b) is fixed to the holder (17), the stopper (28a, 28b) including a pair of contact members opposed to both pivot-directional lateral faces of the pivot member maintained in the neutral position at predetermined clearances.

## Patentansprüche

1. Nutbearbeitungswerkzeug (2) für eine Dünnschichtsolarzelle, wobei das Nutbearbeitungswerkzeug (2) schwenkbar durch einen Halter (17) gehalten ist und konfiguriert ist, relativ zu einem integrierten Substrat der Dünnschichtsolarzelle zusammen mit dem Halter (17) entlang einer prospektiven Schreiblinie auf dem integrierten Substrat hin- und her bewegt zu werden, um eine Nut auf dem integrierten Substrat auszubilden, während ein Schwenkwinkel des Nutbearbeitungswerkzeugs (2) in einer ausgehenden Bewegung und einer zurückkehrenden Bewegung verwendet wird, wobei das Nutbearbeitungswerkzeug (2) umfasst:
einen Werkzeugkörper (36), der durch den Halter (17) gehalten ist; und
ein Klingenende (37), das auf einer Spitze des Werkzeugkörpers (36) ausgebildet ist, wobei das Klingenende (37) eine Schnittkante (38a) auf der ausgehenden Seite und eine Schnittkante (38b) auf der zurückkehrenden Seite auf einer Spitze davon in den Hin- und Herbewegungsrichtungen aufweist, wobei die Schnittkante (38a) auf der ausgehenden Seite in der ausgehenden Bewegung verwendet wird, und die Schnittkante (38b) auf der Rückkehrseite in der zurückkehrenden Bewegung verwendet wird,
wobei das Klingenende (37) ein Paar einer seitlichen Fläche (37a) an der ausgehenden Seite und einer seitlichen Fläche (37b) an der Rückkehrseite in den Hin- und Herbewegungsrichtungen aufweist, wobei die seitlichen Flächen (37a, 37b) an der ausgehenden Seite und der Rückkehrseite gekippt und symmetrisch ausgebildet sind, um eine Breite des Klingenendes (37) in den Hin- und Herbewegungsrichtungen zu der Spitze des Klingenendes (37) zu reduzieren.

2. Nutbearbeitungswerkzeug (2) für eine Dünnschichtsolarzelle, nach Anspruch 1, wobei
jede der Schnittkanten (38a, 38b) des Klingenendes (37) eine lineare Form aufweist, und
ein Spannwinkel (α) der seitlichen Fläche (37a) an der ausgehenden Seite mit Bezug auf die Schnittkante (38a) an der ausgehenden Seite und ein Spannwinkel der seitlichen Fläche (37b) an der Rückkehrseite mit Bezug auf Schnittkante (38b) an der Rückkehrseite entsprechend eingestellt sind, größer als oder gleich wie 50 Grad und kleiner als oder gleich wie 80 Grad zu sein.

3. Nutbearbeitungswerkzeug (2) für eine Dünnschichtsolarzelle, nach Anspruch 2, wobei
die Breite (W) der Spitze des Klingenendes (37) in den Nutausbildungsrichtungen eingestellt ist, größer als oder gleich wie 50 µm und kleiner als oder gleich wie 200 µm zu sein.

4. Nutbearbeitungsgerät für eine Dünnschichtsolarzelle, wobei das Nutbearbeitungsgerät konfiguriert ist,
ein Nutbearbeitungswerkzeug (2) relativ zu einem integrierten Substrat (W) der Dünnschichtsolarzelle entlang einer prospektiven Nebenschreiblinie auf dem integrierten Substrat zum Ausbilden einer Nut auf dem integrierten Substrat (W) zu bewegen, wobei das Nutbearbeitungsgerät umfasst:
einen Tisch (1), der es dem integrierten Substrat ermöglicht, darauf vorgesehen zu sein;
einen Kopf (3), der es ermöglicht, das Nutbearbeitungswerkzeug (2) nach den Ansprüchen 1 bis 3 darin anzubringen; und
einen Bewegungsmechanismus (6), der konfiguriert ist, den Tisch (1) und den Kopf (3) relativ zueinander innerhalb einer horizontalen Ebene zu bewegen, wobei
der Kopf hat:
einen Halter (17), der nach oben und unten beweglich ist;
ein Schwenkelement (18), das das Nutbearbeitungswerkzeug (2) hält, wobei das Schwenkelement (18) schwenkbar durch den Halter (17) um eine Schwenkachse gelagert ist, die rechtwinklig zu den Nutausbildungsrichtungen angeordnet ist; und
ein Druckelement (19), das konfiguriert ist, das durch den Halter (17) gehalten Nutbearbeitungswerkzeug (2) auf das integrierte Substrat (W) mit einer vorbestimmten Kraft zu drücken.

5. Nutbearbeitungsgerät für eine Dünnschichtsolarzelle, nach Anspruch 4, wobei
das Schwenkelement (18) um die Schwenkachse innerhalb eines Winkelbereichs von ± 5 Grad schwenkbar ist.

6. Nutbearbeitungsgerät für eine Dünnschichtsolarzelle, nach Anspruch 5, außerdem mit:
einer Neutralpositionsbeibehaltungseinheit (29a, 29b), die konfiguriert ist, das Schwenkelement (18) mit Ausnahme während der Nutbearbeitung in einer neutralen Position zu halten; und
einem Anschlag (28a, 28b), der konfiguriert ist, das Schwenkelement (18) zu beschränken, über den Winkelbereich von ± 5 Grad zu schwenken.

7. Nutbearbeitungsgerät für eine Dünnschichtsolarzelle, nach Anspruch 6, wobei
die Neutralpositionsbeibehaltungseinheit (29a, 29b) ein Paar elastische Elemente hat, die das Schwenkelement (18) zwischen sich aufnehmen, wobei die elastischen Elemente konfiguriert sind, das Schwenkelement (18) zu der neutralen Position zu drängen.

8. Nutbearbeitungsgerät für eine Dünnschichtsolarzelle, nach Anspruch 7, wobei
die elastischen Elemente Spiralfedern sind.

9. Nutbearbeitungsgerät für eine Dünnschichtsolarzelle, nach Anspruch 7, wobei
die elastischen Elemente beide aus einem weichen Kautschuk hergestellt sind.

10. Nutbearbeitungsgerät für eine Dünnschichtsolarzelle, nach Anspruch 7, wobei
die elastischen Elemente Scheibenfedern sind.

11. Nutbearbeitungsgerät für eine Dünnschichtsolarzelle, nach Anspruch 6, wobei
die Neutralpositionsbeibehaltungseinheit (29a, 29b) ein Magnetelement hat, das zumindest auf einer oberen Spitze des Schwenkelements (18) vorgesehen ist; und
einen auf dem Halter (17) vorgesehenen Magneten, wobei der Magnet dem magnetischen Element in einem vorbestimmten Freiraum gegenüberliegt.

12. Nutbearbeitungsgerät für eine Dünnschichtsolarzelle nach einem der Ansprüche 6 bis 11, wobei
der Anschlag (28a, 28b) an dem Halter (17) befestigt ist, der Anschlag (28a, 28b) ein Paar Berührungsoberflächen hat, die zwischen sich die obere Spitze des Schwenkelements (18) aufnehmen, die mit vorbestimmten Freiräumen in der neutralen Position beibehalten ist.

13. Nutbearbeitungsgerät für eine Dünnschichtsolarzelle nach einem der Ansprüche 6 bis 11, wobei
der Anschlag (28a, 28b) an dem Halter (17) befestigt ist, wobei der Anschlag (28a, 28b) ein Paar Berührungselemente hat, die beiden in Schwenkrichtung seitlichen Flächen des Schwenkelements gegenüberliegen, das mit vorbestimmten Freiräumen in der neutralen Position beibehalten ist.

## Revendications

1. Outil de traitement de rainure (2) pour une cellule solaire à couche mince, l'outil de traitement de rainure (2) étant maintenu de manière pivotante par un support (17) et configuré pour être mis en mouvement de va-et-vient par rapport à un substrat intégré de la cellule solaire à couche mince conjointement avec le support (17) le long d'une ligne de traçage prospective sur le substrat intégré pour former une rainure sur le substrat intégré tout en modifiant un angle d'inclinaison de l'outil de traitement de rainure (2) en mouvement de sortie et mouvement de retour, l'outil de traitement de rainure (2) comprenant :
un corps d'outil (36) maintenu par le support (17) ; et
une extrémité de lame (37) formée sur une pointe du corps d'outil (36), l'extrémité de lame (37) incluant une arête tranchante côté sortie (38a) et une arête tranchante côté retour (38b) sur une pointe de celle-ci dans des directions de va-et-vient, l'arête tranchante côté sortie (38a) étant utilisée en mouvement de sortie et l'arête tranchante côté retour (38b) étant utilisée en mouvement de retour,
dans lequel l'extrémité de lame (37) inclut une paire d'une face latérale côté sortie (37a) et d'une face latérale côté retour (37b) dans les directions de va-et-vient, les faces latérales côté sortie et côté retour (37a, 37b) étant inclinées et formées symétriquement pour réduire une largeur de l'extrémité de lame (37) dans les directions de va-et-vient vers la pointe de l'extrémité de lame (37).

2. Outil de traitement de rainure (2) pour une cellule solaire à couche mince selon la revendication 1, dans lequel
chacune des arêtes tranchantes (38a, 38b) de l'extrémité de lame (37) a une forme linéaire, et
un angle de coupe (a) de la face latérale côté sortie (37a) par rapport à l'arête tranchante côté sortie (38a) et un angle de coupe de la face latérale côté retour (37b) par rapport à l'arête tranchante côté retour (38b) sont fixés respectivement pour être supérieur ou égal à 50 degrés et inférieur ou égal à 80 degrés.

3. Outil de traitement de rainure (2) pour une cellule solaire à couche mince selon la revendication 2, dans lequel
la largeur (w) de la pointe de l'extrémité de lame (37) dans des directions de formation de rainure est fixée pour être supérieure ou égale à 50 µm et inférieure ou égale à 200 µm.

4. Dispositif de traitement de rainure pour une cellule solaire à couche mince, le dispositif de traitement de rainure étant configuré
pour déplacer un outil de traitement de rainure (2) par rapport à un substrat intégré (W) de la cellule solaire à couche mince le long d'une ligne de sous-traçage prospective sur le substrat intégré pour former une rainure sur le substrat intégré (W), le dispositif de traitement de rainure comprenant :
une table (1) permettant d'y disposer le substrat intégré ;
une tête (3) permettant d'y fixer l'outil de traitement de rainure (2) selon l'une des revendications 1 à 3 ; et
un mécanisme de déplacement (6) configuré pour déplacer la table (1) et la tête (3) l'une par rapport à l'autre au sein d'un plan horizontal, dans lequel la tête inclut : un support (17) mobile vers le haut et vers le bas ;
un élément pivotant (18) maintenant l'outil de traitement de rainure (2), l'élément pivotant (18) étant supporté de manière pivotante par le support (17) autour d'un axe de pivotement agencé perpendiculairement aux directions de formation de rainure ; et
un élément de pression (19) configuré pour presser l'outil de traitement de rainure (2) maintenu par le support (17) sur le substrat intégré (W) avec une force prédéterminée.

5. Dispositif de traitement de rainure pour une cellule solaire à couche mince selon la revendication 4, dans lequel
l'élément pivotant (18) peut pivoter autour de l'axe de pivotement au sein d'une plage angulaire de ± 5 degrés.

6. Dispositif de traitement de rainure pour une cellule solaire à couche mince selon la revendication 5, comprenant en outre :
une unité de maintien de position neutre (29a, 29b) configurée pour maintenir l'élément pivotant (18) dans une position neutre sauf pendant le traitement de la rainure ; et
une butée (28a, 28b) configurée pour restreindre un pivotement de l'élément pivotant (18) dans la plage angulaire de ± 5 degrés.

7. Dispositif de traitement de rainure pour une cellule solaire à couche mince selon la revendication 6, dans lequel
l'unité de maintien de position neutre (29a, 29b) inclut une paire d'éléments élastiques intercalant l'élément pivotant (18) entre eux, les éléments élastiques étant configurés pour pousser l'élément pivotant (18) vers la position neutre.

8. Dispositif de traitement de rainure pour une cellule solaire à couche mince selon la revendication 7, dans lequel
les éléments élastiques sont des ressorts hélicoïdaux.

9. Dispositif de traitement de rainure pour une cellule solaire à couche mince selon la revendication 7, dans lequel
les éléments élastiques sont tous deux réalisés en caoutchouc souple.

10. Dispositif de traitement de rainure pour une cellule solaire à couche mince selon la revendication 7, dans lequel
les éléments élastiques sont des ressorts à lames.

11. Dispositif de traitement de rainure pour une cellule solaire à couche mince selon la revendication 6, dans lequel
l'unité de maintien de position neutre (29a, 29b) inclut un élément magnétique disposé au moins sur une pointe supérieure de l'élément pivotant (18) ; et
un aimant disposé sur le support (17), l'aimant étant opposé à l'élément magnétique avec un débattement prédéterminé.

12. Dispositif de traitement de rainure pour une cellule solaire à couche mince selon l'une des revendications 6 à 11, dans lequel
la butée (28a, 28b) est fixée au support (17), la butée (28a, 28b) incluant une paire de surfaces de contact intercalant entre elles la pointe supérieure de l'élément pivotant (18) maintenue dans la position neutre avec des débattements prédéterminés.

13. Dispositif de traitement de rainure pour une cellule solaire à couche mince selon l'une des revendications 6 à 11, dans lequel
la butée (28a, 28b) est fixée au support (17), la butée (28a, 28b) incluant une paire d'éléments de contact opposés aux deux faces latérales de l'élément pivotant dans la direction de pivotement, maintenues dans la position neutre avec des débattements prédéterminés.
